# EUROPEAN PATENT APPLICATION

(11) **EP 0 723 300 A2**
(43) Date of publication of application: **24.07.1996**
(21) Application number: 96100709.3
(22) Date of filing: 18.01.1996
(51) Int. Cl.: H01L 29/812, H01L 29/872, H01L 29/10

(54) **Semiconductor device with Schattky electrode**

(30) Priority: 18.01.1995 JP 5869/95
(71) Applicant: MURATA MANUFACTURING CO., LTD., Nagaokakyo-shi Kyoto-fu 226 (JP)
(72) Inventor: Marukawa, Takashi, Nagaokakyo-shi, Kyoto-fu (JP)
(74) Representative: Laufhütte, Dieter, Dr.-Ing.

(57) **Abstract**

A semiconductor device such as a GaAs MESFET or a Schottky barrier diode. The GaAs MESFET has a Schottky electrode having a breakdown voltage of improved uniformity and reliability. The Schottky barrier diode has forward and reverse current-voltage characteristics of improved uniformity and reliability. First, an n⁺ active layer is formed on a substrate of a compound semiconductor. A source electrode and a drain electrode are formed on the n⁺ active layer. A high-resistivity layer is formed between the source and drain electrodes within the n⁺ active layer by plasma processing. The high-resistivity layer has a surface state of 0.6-0.8 eV. A Schottky electrode forming a Schottky junction with the active layer is formed on the high-resistivity layer.

## Description

The present invention relates to a semiconductor device and, more particularly, to a high-power semiconductor device such as a Schottky gate field-effect transistor or Schottky gate barrier diode having an electrode forming a Schottky contact with an active layer.

GaAs Schottky gate field-effect transistors (GaAs MESFETs) can be used as high-power semiconductor devices such as RF amplifiers used in the RF frequency range because of their excellent RF characteristics, i.e., high-speed operation.

However, the GaAs MESFET has the disadvantage of having low drain breakdown voltage and low gate breakdown voltage due to the influences of high-density surface-defect level existing at the surface of the active layer of the GaAs substrate and also due to the influences of the concentration of electric field in the active layer located immediately under the Schottky electrode. Especially for high-power GaAs MESFETs, it is essential to improve the drain breakdown voltage and gate breakdown voltage in order to increase the maximum output power and to improve the reliability of the devices.

For these reasons, adoption of various means has been discussed and used to improve the breakdown voltages of high-power GaAs MESFETs, to suppress tunneling phenomenon, to improve the barrier height, and to reduce the leakage current. These various means include the LDD (lightly doped drain) structure and step recessed structure.

More specifically, the improving methods include: (1) A material for a gate electrode is chosen to increase the Schottky barrier height; (2) The interface of the GaAs substrate is specially processed to improve the gate breakdown voltage; and (3) A buffer layer is formed on the active layer over the GaAs substrate to improve the gate breakdown voltage.

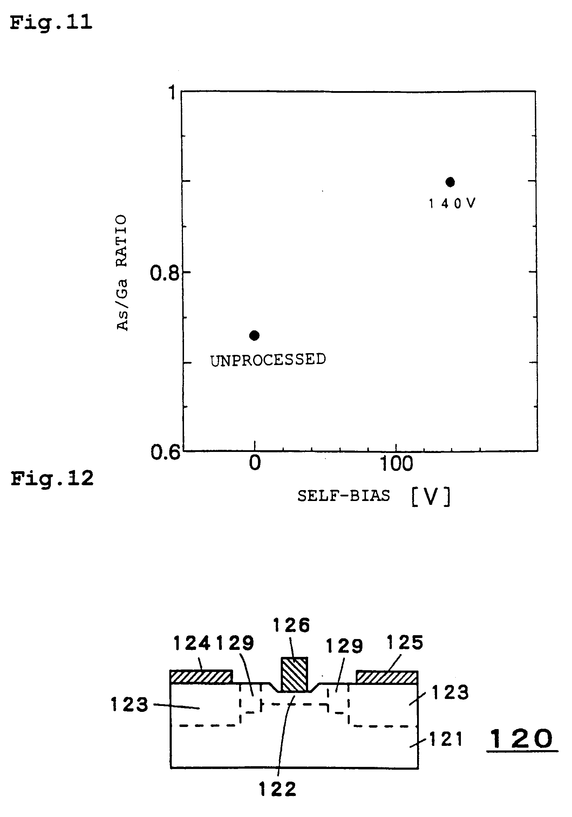

Referring to Fig. 12, a GaAs MESFET 120 of the LDD structure has an n active layer 122, n⁺ active layers 123, and n' active layers 129. A Schottky electrode 126 is formed on the n active layer 122. A source electrode 124 and a drain electrode 125 are formed on the n⁺ active layers 123, respectively. The n' active layers 129 are located between the n active layer 122 and the n⁺ layers 123, and have a carrier concentration lower than that of the n⁺ active layers 123. This prevents the intensity of the electric field at the interfaces between the n active layer 122 and the n⁺ active layers 123 from becoming excessively large. Hence, the drain breakdown voltage and gate breakdown voltage can be improved.

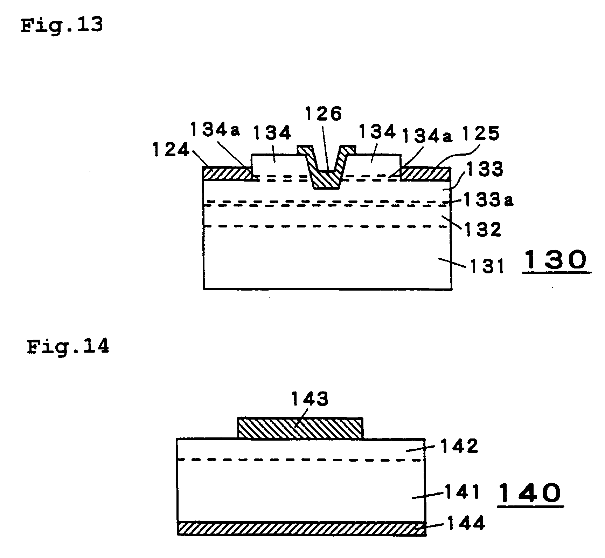

Shown in Fig. 13 is a GaAs MESFET, generally indicated by numeral 130. This FET 130 comprises a semi-insulating GaAs substrate 131 having an active layer 133. An undoped GaAs layer 134 is grown as a buffer layer on the active layer 133 at a low temperature. In this GaAs MESFET 130, current limitation which would otherwise be caused by channel confining between the gate and drain and between the gate and source does not occur. Rather, effects comparable to the effects of the LDD structure or the step recessed structure are obtained. Furthermore, the undoped GaAs layer 134 which is a buffer layer formed at a low temperature is a layer of a non-stoichiometry composition having an intentionally increased As/Ga ratio. Therefore, the surface state density is increased and thus the undoped GaAs layer 134 is a high-resistivity layer. As a consequence, the gate breakdown voltage and other factors are improved.

A Schottky barrier diode is available as a semiconductor device making use of a Schottky junction between a semiconductor and a metal. Fig. 14 schematically shows a conventional Schottky barrier diode 140. This diode 140 has a Schottky electrode 143 and an ohmic electrode 144. A depletion layer is formed under the Schottky electrode 143 by the semiconductor-metal contact.
If a reverse voltage is applied between the Schottky electrode 143 and the ohmic electrode 144, the depletion layer located just under the Schottky electrode 143 inhibits flow of a reverse current. Hence, rectification characteristics occur.

However, the conventional GaAs MESFET having the LDD structure or step recessed structure is complex in structure. Moreover, a complex process sequence is required to fabricate this device. The controllability and reliability of the process for manufacturing the conventional device present problems.

Similarly, the GaAs MESFET having the buffer layer needs complicated manufacturing steps, e.g., formation of various layers by molecular beam epitaxy and a dry etching process such as a reactive ion etching process. It is difficult to control these manufacturing steps. Consequently, the manufacturing cost is increased.

In the prior art of the Schottky barrier diode, it is necessary to sufficiently lower the potential barrier of the depletion layer in order to permit flow of a forward current. A voltage applied to lower the potential barrier in the depletion layer contributes entirely to a voltage drop in the forward direction and so the forward voltage is increased. Although the GaAs Schottky barrier diode has excellent RF characteristics, it has a larger forward voltage and a larger power loss than the silicon diode for the reasons described above.

Moreover, if a reverse voltage greater than a certain value is applied to the prior art Schottky barrier diode, electron-hole pairs are generated, thus inducing avalanche breakdown. The breakdown voltage when a reverse voltage is applied is determined by this avalanche breakdown voltage and hence is low. This breakdown voltage may be improved by lowering the dopant concentration in the GaAs substrate. However, as the dopant concentration is reduced, the forward current also decreases.

The object of the present invention is to solve the aforementioned problems associated with the related art and provide a semiconductor device such as a GaAs MESFET having a Schottky electrode exhibiting a breakdown voltage of improved uniformity and reliability.

It is another object of the invention to provide a semiconductor device such as a Schottky barrier diode having forward and reverse current-voltage characteristics of improved uniformity and reliability.

According to the present invention a semiconductor device includes a compound semiconductor substrate, an active layer formed on the substrate, a Schottky electrode forming a Schottky junction with the active layer, and a high-resistivity layer formed at least in a part of a zone included in the region of the active layer over which the Schottky electrode is formed. This semiconductor device is characterized in that the high-resistivity layer is formed by plasma processing and has a surface state of about 0.6 to 0.8 eV.

The high-resistivity layer formed at least in a part of the zone included in the region of the active layer over which the Schottky electrode is formed depends on a surface state created by arsenic-rich defects which are produced by the plasma processing. The surface state has an activation energy of about 0.6 to 0.8 eV and a density of about 1 x 10¹⁴ cm⁻³. The high-resistivity layer of improved uniformity and reliability can be formed in the active layer.

Other objects and features of the invention will be described with reference to examples of the invention which are shown in the drawings. In the drawings the following is shown:
Figs. 1(a) to 1(d) are cross-sectional views of a GaAs MESFET according to the present invention, illustrating the process sequence for fabricating the GaAs MESFET;
Fig. 2 is a cross-sectional view of another GaAs MESFET according to the invention;
Fig. 3 is a cross-sectional view of a further GaAs MESFET according to the invention;
Fig. 4 is a cross-sectional view of a yet other GaAs MESFET according to the invention;
Fig. 5 is a diagram showing the relations of gate leakage current to gate-drain voltage for the GaAs MESFET shown in Figs. 1(a)-1(d) and for the prior art device;
Fig. 6 is a cross-sectional view of a Schottky barrier diode according to the invention;
Fig. 7 is a cross-sectional view of another Schottky barrier diode according to the invention;
Fig. 8 is a cross-sectional view of a further Schottky barrier diode according to the invention;
Fig. 9 is a cross-sectional view of a yet other Schottky barrier diode according to the invention;
Fig. 10 is a diagram showing the dependence of the As/Ga ratio on the depth in an active layer, the dependence being obtained by analyses using TEM;
Fig. 11 is a diagram showing the dependence of the As/Ga ratio in high-resistivity layers on self-bias, the dependence being obtained by analyses using XPS;
Fig. 12 is a cross-sectional view of the related art GaAs MESFET having the LDD structure;
Fig. 13 is a cross-sectional view of a conventional GaAs MESFET having an improved withstand voltage; and
Fig. 14 is a cross-sectional view of the related art Schottky barrier diode.

Hereinafter, the present invention will be explained with reference to the accompany drawings. It is to be noted that like components are indicated by like reference numerals in various figures and that those components which are commonly used in plural embodiments will not be described repeatedly.

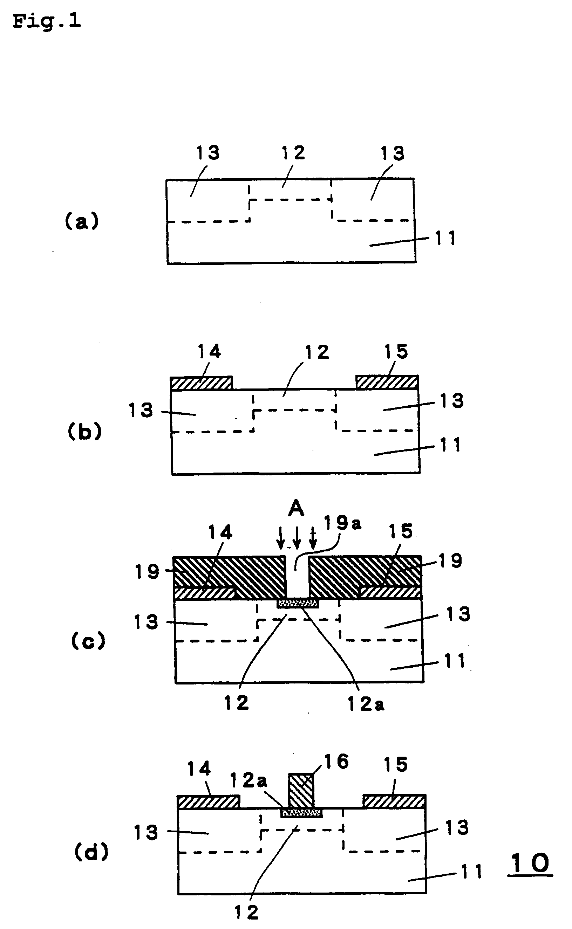

Fig. 1(d) shows a schematic cross section of a GaAs MESFET 10 according to a first embodiment of the present invention. The GaAs MESFET 10 includes a semiconductor substrate, an active layer, a source electrode 14, drain electrode 15, gate electrode 16, and a high-resistivity layer 12a. The active layer is formed on the face of the substrate 11 and composed of an n active layer 12 and n⁺ active layers 13. The n⁺ active layers 13 interpose the n active layer 12 which acts as a channel layer. The source electrode 14 and the drain electrode 15 are formed on the n⁺ active layers 13 and ohmic contact with the n⁺ active layers 13. The high-resistivity layer 12a is formed in the n active layer 12 and on the surface of the n active layer 12. The gate electrode 16 is formed on the high-resistivity layer 12a to form a Schottky contact with the high-resistivity layer 12a.

Hereinafter, the fabrication method of GaAs MESFET 10 is explained with reference to Figs. 1(a)-1(d). As shown in Fig. 1(a), the active layer which is composed of the n active layer 12 and n⁺ active layers 13 is formed on the face of the substrate 11 consisting of semi-insulating GaAs. The n⁺ active layers 13 are formed by heavily implanting opposite sides of the n active layer 12, i.e., the source and drain regions, with n-type ions. The n active layer 12 is formed by introducing n-type ions. For example, the n-type active layer 12 is formed by introducing n-type ions into the surface of the semi-insulating substrate 11 at an implantation energy of 80 keV and a dose of 6 x 10¹² cm⁻² by ion implantation, and then the surface excluding the region over which the n⁺ active layers 13 are to be formed is coated with resist (not shown). Using this resist as a mask, n-type ions are introduced at an implantation energy of 120 keV and a dose of 2 x 10¹³ cm⁻². In this way, the n⁺ active layers 13 are formed under the regions where the source and drain regions are to be formed, respectively.

Then, as shown in Fig. 1(b), ohmic metallization of an Au-Ge/Ni-based material is deposited on the n⁺ active layers 13, thus forming a source electrode 14 and a drain electrode 15. Both electrodes 14 and 15 are heated-treated to change them into an alloy.

Thereafter, as shown in Fig. 1(c), using a resist layer 19 as a mask for formation of a gate, a plasma is directed to only vicinities of the gate of the n active layer 12 in the direction indicated by the arrow *A* through an opening 19a. As a result of this plasma processing, the high-resistivity layer 12a is formed in the n active layer 12 encompassing the region over which the Schottky electrode is to be formed.

This plasma processing can be carried out, for example, using a reactive ion etching (RIE) apparatus. Typical examples of a gas species becoming a plasma source include O₂, N₂, Ar, CF₄, CHF₃, and H₂. Any arbitrary gas can be used as long as it becomes a plasma source. Furthermore, these gas species may be used in combination. However, it is preferable to use a gas including O₂ or N₂, and more preferable to use a gas including O₂. During this plasma processing, the substrate is preferably kept at a room temperature. As is apparent from the aforementioned explanation, impurity ions are neither implanted nor doped into the substrate during this process. Therefore, the high-resistivity layer 12a has substantially the same impurity concentration as that of the n active layer 12.

According to the present invention, a surface state is introduced in a shallow surface region of the n active layer during the plasma processing and acts as a resistance for electrons in the n active layer. Therefore, the high-resistivity layer having a small thickness can be formed without an activation process.

On the other hand, a semiconductor layer having a high resistance can be also formed by an ion implanting method. However, in the case, it is necessary to activate impurity ions implanted into a semiconductor region to be a high-resistivity layer. Moreover, the impurity ions are deeply implanted into the semiconductor region, which results in formation of a high-resistivity layer having a large thickness. Such a high-resistivity layer having a large thickness may degrade a forward characteristics.

Finally, as shown in Fig. 1(d), the semiconductor substrate 11 is dipped in 6N-HCl (6-normal hydrochloric acid) for 1 minute to remove the oxide film (not shown) formed on the surface of the high-resistivity layer 12a. Then, a Schottky electrode 16 made of Ti/Pt/Au, Al, or other material is formed. Thus, the GaAs MESFET 10 is completed.

The structure of the GaAs MESFET 10 and its fabrication method are characterized in that the region located immediately under the Schottky electrode 16 forming a Schottky junction and a surrounding region are subjected to the plasma processing. In this way, the high-resistivity layer 12a is formed in the n active layer 12 by the plasma processing. Accordingly, the manufacturing steps of the above example are similar to those of the prior art method except for the plasma processing.

In the above example, recesses are not etched. Alternatively, the Schottky electrode may be formed by etching recesses.

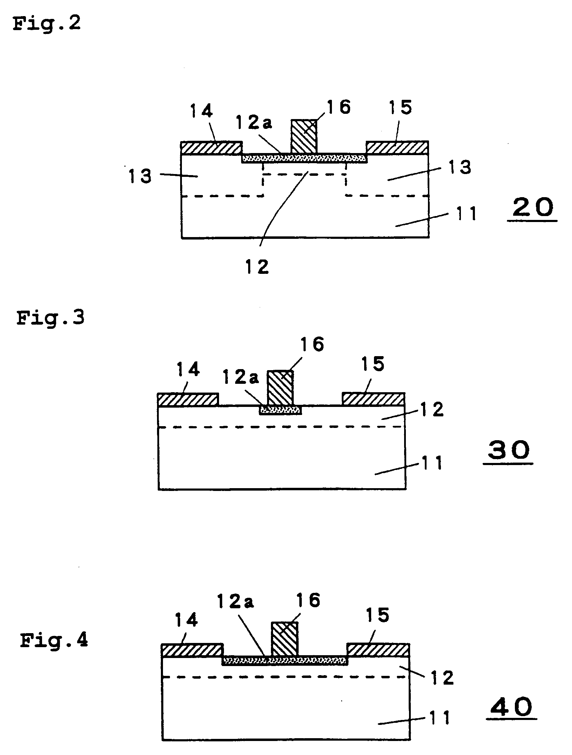

Fig. 2 is a cross-sectional view of another semiconductor device according to the invention. This device is also a GaAs MESFET in which the n⁺ active layers 13 having a high concentration of carriers are formed in the source and drain regions. This GaAs MESFET, indicated by numeral 20, is similar to the GaAs MESFET 10 described previously in conjunction with Figs. 1(a)-1(d) except that the substrate 11 is exposed to a plasma using the source and drain electrodes, 14 and 15, as a mask before formation of the resist layer (not shown) for formation of a gate electrode 16. As a result, the high-resistivity layer 12a is formed on the surface of the n active layer 12 between the electrodes 14 and 15 and also on parts of the surfaces of the n⁺ active layers 13.

Fig. 3 is a cross-sectional view of a further semiconductor device according to the invention. This semiconductor device is a GaAs MESFET comprising a semiconductor substrate 11 consisting of a semi-insulating GaAs. Only an n active layer 12 is formed on the surface of the substrate 11 by ion implantation or molecular beam epitaxy. This GaAs MESFET, generally indicated by reference numeral 30, is different from the GaAs MESFET 10 shown in Fig. 1(d) in that only the n active layer 12 is formed on the substrate and n⁺ layers 13 are not formed in the substrate 11. The high-resistivity layer 12a is formed in and near the region located just under the Schottky electrode 16 forming a Schottky junction.

Fig. 4 is a cross-sectional view of a still other semiconductor device according to the invention. This semiconductor device is a GaAs MESFET comprising a semiconductor substrate 11 consisting of a semi-insulating GaAs. Only an n active layer 12 is formed on the surface of the substrate 11 by ion implantation or molecular beam epitaxy. This GaAs MESFET, generally indicated by reference numeral 40, differs from the GaAs MESFET 30 shown in Fig. 3 in that plasma irradiation is performed, using the source and drain electrodes 14 and 15, respectively, as a mask before formation of a resist layer (not shown) for creating a gate electrode 16. As a consequence, a high-resistivity layer 12a is formed on the surface of the n active layer 12 between both electrodes 14 and 15, in the same way as in the case of the GaAs MESFET 20 shown in Fig. 2.

In the GaAs MESFETs 30 and 40 each having only the n active layer 12 as shown in Figs. 3 and 4, respectively, the gate breakdown voltage can be improved and the leakage current can be reduced, in the same manner as the GaAs MESFETs 10 and 20.

To examine the characteristics of the devices of the above-described examples, the GaAs MESFET 10 was fabricated. This structure was plasma-processed with an RIE apparatus under the conditions given in Table 1, using O₂ gas as a gas species acting as a plasma source.

**Table 1**

| Flow rate (sccm) | Pressure (mTorr) | RF Power (W) | Self-bias (V) | Process time (min) |
|---|---|---|---|---|
| 10 | 100 | 30 | 90 | 30 |

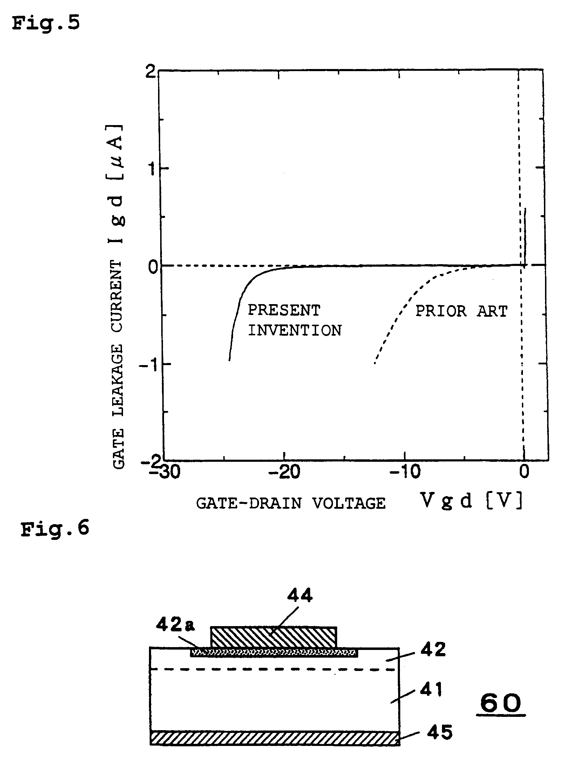

The prior art GaAs MESFET was manufactured by the conventional method under conditions similar to the conditions of the above example of the invention except that plasma processing was not performed. The GaAs MESFETs of the above example of the invention and of the conventional structure had a gate length of 0.5 µm, a gate width of 100 µm, and an n⁺ active layer spacing of 2.5 µm. The relation of the gate leakage current I_{gd} to the gate-drain voltage V_{gd} was measured for both kinds of devices. These gate current-voltage characteristics are shown in Fig. 5. In Fig. 5, the gate current-voltage characteristic curve of the above example of the invention is indicated by the solid line, whereas the characteristic curve of the conventional structure is indicated by the broken line. As can be seen from this graph, the above example of the invention has an improved gate breakdown voltage and a reduced leakage current compared with the prior art structure. It is thought that the high-resistivity layer is as thick as possible in order to improve the gate breakdown voltage. However, if the thickness of the high-resistivity layer is too large, forward characteristics of the GaAs MESFET may degrade. Therefore, the high-resistivity layer has preferably a thickness less than about 100 nm, and more preferably a thickness less than about 50 nm, i.e., it is preferable that the high-resistivity layer is formed from the surface of the surface of the n active layer to a depth less than about 50 nm.

Fig. 6 is a cross-sectional view of a Schottky barrier diode according to the invention. This Schottky barrier diode, generally indicated by reference numeral 60, has a Schottky electrode 44 and a high-resistivity layer 42a. A region located just under the Schottky electrode 44 and a surrounding region are plasma-processed to form the high-resistivity layer 42a. That is, a region wider than the Schottky electrode 44 is plasma-processed. In this Schottky barrier diode 60, the high-resistivity layer 42a mitigates the electric field concentration at the ends of the Schottky electrode 44. As a result, the reverse current-voltage characteristics of the Schottky barrier diode are improved without degrading the forward characteristics.

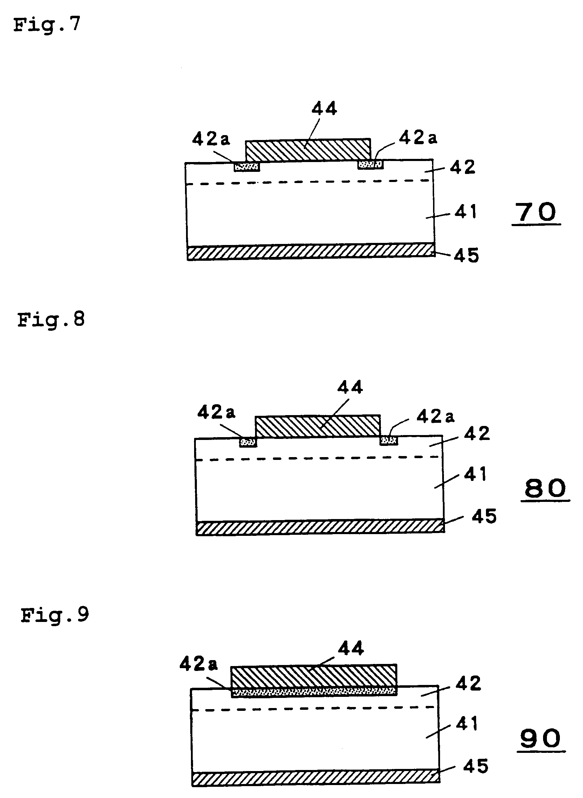

Fig. 7 is a cross-sectional view of a further Schottky barrier diode according to the invention. This Schottky barrier diode, generally indicated by reference numeral 70, also has a Schottky electrode 44 and a high-resistivity layer 42a that is formed by plasma-processing only a region close to a region which is just under the peripheral portion of the Schottky electrode 44 and a surrounding region.

Also in this Schottky barrier diode 70, the high-resistivity layer 42a mitigates the electric field concentration at the ends of the Schottky electrode 44. Hence, the reverse current-voltage characteristics are greatly improved while maintaining the forward characteristics, in the same way as the example previously described in connection with Fig. 6.

Fig. 8 is a cross-sectional view of a yet other Schottky barrier diode according to the invention. This Schottky barrier diode, generally indicated by reference numeral 80, also has a Schottky electrode 44 and a high-resistivity layer 42a. A region which is located just outside the peripheral portion of the Schottky electrode 44 and a nearby region outside said peripheral region are plasma-processed to form the high-resistivity layer 42a.

Also in this Schottky barrier diode 80, the high-resistivity layer 42a mitigates the electric field concentration at the ends of the Schottky electrode 44. As a consequence, the reverse current-voltage characteristics are greatly improved while maintaining the forward characteristics, in the same way as the example already described in conjunction with Fig. 6. Since the Schottky barrier diode 80 is designed in this way, the high-resistivity layer 42a may also be formed by plasma processing after formation of the Schottky electrode 44.

Fig. 9 is a cross-sectional view of a still other Schottky barrier diode according to the invention. This Schottky barrier diode, generally indicated by reference numeral 90, also has a Schottky electrode 44 and a high-resistivity layer 42a. The whole region located just under the Schottky electrode 44 is plasma-processed to form the high-resistivity layer 42a.

In this Schottky barrier diode 90, the n active layer 42 is made to have a high resistivity in the region immediately under the Schottky electrode 44. This permits a reduction in the barrier height of the Schottky electrode 44. Consequently, the forward characteristics of the Schottky barrier diode 90 can be improved without sacrificing the reverse characteristics.

In the structure shown in Fig. 9, the Schottky electrode 44 registers with the high-resistivity layer 42a. The high-resistivity layer 42a may also be formed in a region narrower than the Schottky electrode 44.

We now discuss the examples shown in Figs. 6-9. In each of these Schottky barrier diodes, the high-resistivity layer is formed by plasma-processing substantially the whole region just under the Schottky electrode. As a consequence, the forward characteristics can be improved. Where a peripheral portion of the Schottky electrode or a region adjacent to the peripheral portion is plasma-processed to form the high-resistivity region, the reverse characteristics can be improved. Where the high-resistivity layer is formed by plasma-processing the whole region just under the Schottky electrode or a region surrounding that region, both forward and reverse characteristics of the Schottky barrier diode can be improved.

To examine the physics of the formation of the high-resistivity layers of the above all examples, O₂ gas was used as a gas species becoming a plasma source. Plasma processing was performed by an RIE apparatus under the conditions listed in Table 2 to form the high-resistivity layers of the examples. Analyses were made by TEM (transmission electron microscopy), XPS (x-ray photoelectron spectroscopy), and ICTS (isothermal capacitance transient spectroscopy).

**Table 2**

| Flow rate (sccm) | Pressure (mTorr) | RF Power (W) | Self-bias (V) | Process time (min) |
|---|---|---|---|---|
| 10 | 50 | 50 | 140 | 1 |

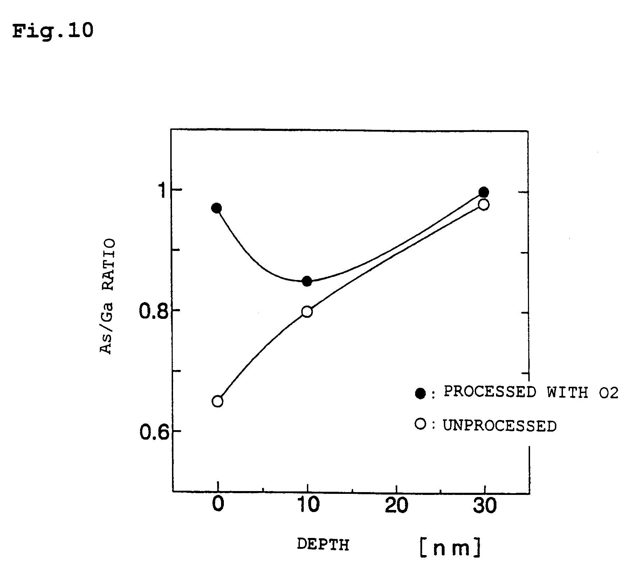

First, the relation of the As/Ga ratio to the depth in the n active layer was examined by TEM. The results are shown in Fig. 10. Plotted on the horizontal axis of Fig. 10 is the depth in the n active layer, i.e., the distance from the surface. Plotted on the vertical axis is the As/Ga ratio. Indicated by the black circles are relations of the As/Ga ratio to the depth for the illustrated example. Indicated by the white circles are relations of the As/Ga ratio to the depth for the prior art structure not undergone plasma processing. As can be seen from Fig. 10, the As/Ga ratio of the present example is larger in the region spaced less than 10 nm from the surface of the n active layer, i.e., in the high-resistivity layer, than that of the prior art structure.

Then, the As/Ga ratio at a location spaced about 7 nm from the surface of the n active layer, i.e., in the high-resistivity layer, was examined by XPS. The results are shown in Fig. 11. Plotted on the horizontal axis of Fig. 11 is self-bias, while plotted on the vertical axis is the As/Ga ratio. As can be seen from this graph, the present example has larger As/Ga ratio than that of the prior art structure not undergone plasma processing.

Then, the activation energy, the density, and the carrier concentration were examined by ICTS. It can be seen from the results that a surface state having an activation energy of about 0.6-0.8 eV from the conduction band edge of GaAs and the surface state density formed in the high-resistivity layer is about 1 x 10¹⁴ cm⁻³. Also, it is discovered that the carrier concentration in the high-resistivity layer is less than one-fifth of that in the n active layer, even though the concentration of the impurity ions is substantially identical to that of the n active layer.

It is understood from the results of these analyses that a uniform and good high-resistivity layer is formed by the surface state having an activation energy of 0.6-0.8 eV and a density of about 1 x 10¹⁴ cm⁻³, the surface state being induced by arsenic-rich defects.

It is to be noted that the conditions, parameters, and other factors of the plasma deposition machine and of the plasma processing are not limited to those of the above examples. Rather, they may be appropriately selected according to the used compound semiconductor substrate and its characteristics.

In the above examples, GaAs MESFETs and Schottky barrier diodes were described. The present invention is characterized in that the region of the active layer of the semiconductor substrate over which the Schottky electrode is formed is plasma-processed or a region close to that region is plasma-processed at least partially before or after the formation of the Schottky electrode. Therefore, the present invention can be applied to high electron-mobility transistors and compound semiconductor devices making use of Schottky junctions of metals with semiconductors such as planar Schottky barrier diodes, as well as to GaAs MESFETs and Schottky barrier diodes. Furthermore, in the case of GaAs MESFETs and Schottky barrier diodes, the invention is not restricted to the structures and manufacturing processes of the above examples. The invention can also be applied to fabrication methods for other structures of semiconductor devices.

As is explained above, according to the present invention, a high-resistivity layer of improved uniformity and reliability can be formed in an active layer by utilizing plasma processing. The high-resistivity layer has a surface state induced by arsenic-rich defects. The surface state is positioned at about 0.6 to 0.8 eV from the conduction band edge of GaAs and its density is about 1 x 10¹⁴ cm⁻³.

The surface state in the high-resistivity layer traps electrons in the active layer, thereby compensating an electronic charge in the active layer and decreasing a potential in and around the active layer just under the Schottky electrode. Hence, GaAs MESFETs and Schottky barrier diodes having Schottky electrodes having breakdown voltages of improved uniformity and reliability can be obtained. Also, Schottky barrier diodes having forward and reverse current-voltage characteristics of improved uniformity and reliability can be fabricated.

## Claims

1. A semiconductor device comprising:
a substrate of a compound semiconductor material;
an active layer formed on a surface of said substrate and occupying a region;
a Schottky electrode forming a Schottky junction with said active layer and located over at least a part of said region occupied by said active layer; and
a high-resistivity layer formed at least in a part of said region occupied by said active layer, said high-resistivity layer having a surface state of about 0.6-0.8 eV.

2. The semiconductor device of claim 1, wherein said high-resistivity layer is created by arsenic-rich defects.

3. The semiconductor device of claim 2, wherein said arsenic-rich defects are produced by plasma processing.

4. The semiconductor device of claim 2, wherein said arsenic-rich defects have a density of about 1 x 10¹⁴ cm⁻³.

5. The semiconductor device of claim 1, wherein said semiconductor device is a GaAs MESFET.

6. The semiconductor device of claim 5, wherein said high-resistivity layer is formed under the entire said Schottky electrode.

7. The semiconductor device of claim 5, wherein said high-resistivity layer is formed in the entire said region including under the entire said Schottky electrode.

8. The semiconductor device of claim 1, wherein said semiconductor device is a Schottky barrier diode.

9. The semiconductor device of claim 8, wherein said high-resistivity layer is formed under the entire said Schottky electrode.

10. The semiconductor device of claim 9, wherein said high-resistivity layer further extends beyond a periphery of said Schottky electrode.

11. The semiconductor device of claim 9, wherein said high-resistivity layer is substantially coextensive with said Schottky electrode.

12. The semiconductor device of claim 9, wherein said high-resistivity layer is formed substantially only in a region beneath and just outside a periphery of said Schottky electrode.

13. The semiconductor device of claim 12, wherein said high-resistivity layer is also formed in a region just within said periphery of said Schottky electrode.

14. A method of manufacturing a semiconductor device comprising the steps of:
forming a substrate of a compound semiconductor material;
forming an active layer on a surface of said substrate and occupying a region;
forming a Schottky electrode which forms a Schottky junction with said active layer and located over at least a part of said region occupied by said active layer; and
forming a high-resistivity layer at least in a part of said region occupied by said active layer, said high-resistivity layer having a surface state of about 0.6-0.8 eV.

15. A method as claimed in claim 14, wherein said high-resistivity layer is formed by a step of plasma processing.
